Europäisches Patentamt

(19) European Patent Office

Office européen des brevets

(11) Publication number : **0 476 879 A2**

(12) # EUROPEAN PATENT APPLICATION

(21) Application number : **91308010.7**

(22) Date of filing : **30.08.91**

(51) Int. Cl.⁵ : **H01L 39/14, H01L 39/24**

(30) Priority : **21.09.90 US 586401**

(43) Date of publication of application :
**25.03.92 Bulletin 92/13**

(84) Designated Contracting States :
**AT BE DE FR GB IT NL SE**

(71) Applicant : **GENERAL ATOMICS**
**3550 General Atomics Court**
**San Diego, California 92121 (US)**

(72) Inventor : **Woolf, Lawrence D.**
**7920 Corte Cardo**
**Carlsbad, California 92009 (US)**
Inventor : **Elsner, Fredrick H.**
**P.O. Box 372**
**Cardiff, California 92007 (US)**
Inventor : **Raggio, William A.**
**P.O. Box A**
**Del Mar, California 92014 (US)**

(74) Representative : **Coxon, Philip et al**
**Eric Potter & Clarkson St. Mary's Court St.**
**Mary's Gate**
**Nottingham NG1 1LE (GB)**

(54) **Apparatus and method for manufacturing an improved ceramic superconductor coated metal fiber.**

(57) An apparatus (10) and method for manufacturing a ceramic superconductor coated electrically conductive fibre (16) comprises a container (12) for holding a nonaqueous solution in which particles of superconductor material are colloidally suspended to form a slurry (14). A relatively low voltage source (24) is provided to influence the slurry (14) with an electric field and this source (24) is connected to a metal fibre (16) to electrically bias the fibre (16) as it is drawn through the slurry (14). Consequently, charged superconductor particles in the slurry (14) attach to the electrically biased fibre (16). A magnet device (44) is provided to influence the particles which are attached to the fibre (16) with a magnetic field which is oriented relative to the fibre (16) to align the superconductor particles on the fibre (16) in a desired orientation. Subsequently, the coated fibre (16) is heated to sinter the aligned particles and establish a ceramic superconductor shell on the electrically conductive fibre substrate (16).

EP 0 476 879 A2

Fig. 1

FIELD OF THE INVENTION

This application is a continuation-in-part of co-pending application Serial No. 289,968, filed December 22, 1988.

The present invention relates to apparatus and methods for manufacturing superconductors. More particularly, the present invention relates to an apparatus which is useful for coating an electrically conductive substrate with a superconductor material. The present invention is particularly, but not exclusively, useful for coating a metal fiber substrate with ceramic superconductor.

BACKGROUND OF THE INVENTION

It is now well-known that certain materials exhibit exceptional electrical conductive properties which have earned them the distinctive designation of superconductors. Though many superconductor materials are known, ways in which superconductor materials can be incorporated into commercially viable products are not so well-known. Indeed, in recent years, extensive efforts have been made to solve many of the problems which confront the manufacturers of superconductor products.

One particular class of superconductor materials which has attracted a great deal of interest for its potential use in commercial products is the so-called 1-2-3 materials that include rare earth elements (RE) and are from the group identified as RE $Ba_2Cu_3O_{7-x}$. For commercial purposes, it has been determined that these materials are particularly effective in a ceramic form which is made by sintering very fine crystalline particles of 1-2-3. Of importance to the present invention is the fact that, due primarily to properties of the rare earth elements in the particular crystalline structure of these 1-2-3 particles, they can be effectively influenced by a magnetic field before they are sintered. Importantly, it is desirable that the superconductor particles have anisotropic magnetic susceptibilities. Further, since the particles can also be charged before they are sintered, they can also be influenced by an electric field.

With the above in mind, one problem which has heretofore confronted persons skilled in the superconductor art concerns how to support the inherently brittle superconductor ceramic. As obvious solution is to use some form of a supporting substrate. Though substrates of various forms may be used, for certain applications a substrate in the form of a fiber, a wire or a ribbon is ideal. Unfortunately, effectively placing a superconductor ceramic on such a substrate is not easy. For one thing, the ceramic needs to be directly attached to the substrate. Furthermore, the superconductor layer should preferably be of uniform thickness and relatively thin. The present invention recognizes that one way in which to use these substrates is to deposit a thin layer of very fine particles of 1-2-3 on the substrate before they are sintered into a ceramic.

Electrophoresis is a well-known process for coating electrically conductive substrates which involves the motion of colloidal particles suspended in a fluid medium due to the influence of an electric field on the medium. Although some superconductor materials are not adversely affected by water, unfortunately, the 1-2-3 material deteriorates when exposed to moisture. Thus, when 1-2-3 superconductor materials are used, the typically used electrophoresis fluid mediums typically used for electrophoresis, which include water, can not be used in a procedure to coat an electrically conductive substrate with fine superconductor particles.

When water is to be avoided, the particular nonaqueous solution which is chosen for the electrophoresis procedure must meet certain specifications. Its selection, therefore, is very important. First, and perhaps most importantly, the chosen solution cannot have deleterious chemical effects on the superconductor material. More specifically, these chemical effects include the decomposition of the 1-2-3 superconductor into other phases such as $BaCuO_2$, $CuO$, $BaCO_3$, $Ba(OH)_2$, etc. which are well-known in the art. Second, as a subsidiary of the first consideration, the superconductor particles should avoid lower melting point eutectic reactions and should not themselves be exposed to substantial amounts of liquid phase at any time during the entire manufacturing process in order to insure proper sintering.

Proper sintering is extremely important due to the fact that the critical temperature ($T_c$) and critical current density ($J_c$) of the resultant ceramic are directly affected by the size of the grains of the superconductor particles. Ideally, each superconductor particle will have a diameter of approximately one (1) micron. If, however, either the superconductor particles melt, or eutectic reactions are encountered during the sintering process, that is, the superconductor particles are exposed to a liquid phase, extensive grain growth occurs, e.g., the superconductor particles will grow into grains having their largest dimensions in the range of ten (10) to thirty (30) microns. This is undesirable because superconductor ceramics with the larger grain sizes tend to microcrack along the grain boundaries when they are oxygenated. The oxygenation heat treatment is typically performed by heating the 1-2-3 superconductor at 400-500°C for times of one (1) hour to one (1) week. The oxygenation changes the structure from tetragonal to orthorhombic, improves the superconducting properties of the 1-2-3 and results in a composition of $REBa_2Cu_3O_{7-x}$ wherein x is nearly zero. Liquid phase also leads to substantial etching of the substrate material. If the substrate is substantially composed of nickel, then the nickel diffuses into the superconductor, leading to greatly reduced values of $T_c$ and $J_c$. The liquid phase also substantially embrittles the substrate. In addition, the liquid phase tends to leave a non-superconducting coating on each grain boundary upon cooling to room temperature, causing a reduction of the superconductor $J_c$. It is for these reasons that the selection of a fluid medium for electrophoresis is so important. In sum, the fluid medium for electrophoresis must not chemically interact with the superconductor material to cause the deleterious eutectic phases.

The present invention recognizes that an electrophoresis procedure can be accomplished using a nonaqueous solution as the fluid medium. Further, the present invention recognizes that a magnetic field will affect the superconductor particles in the medium to align them on the substrate in an optimal orientation. Additionally, the present invention recognizes that a nonaqueous solution can be prepared which will have minimal deleterious chemical effects on the superconductor particles during the electrophoresis procedure and the subsequent sintering of these particles.

In light of the above, it is an object of the present invention to provide an apparatus for attaching superconductor particles to a metal substrate. Another object of the present invention is to provide an apparatus which uses a nonaqueous fluid medium in an electrophoresis procedure to coat an electrically conductive substrate with superconductor particles. Yet another object of the present invention is to provide an apparatus which magnetically aligns superconductor particles in a desired orientation on an electrically conductive substrate during the coating process. Still another object of the present invention is to provide a method for coating an electrically conductive substrate with magnetically aligned superconductor particles. Another object of the present invention is to provide an apparatus for coating electrically conductive substrates that is relatively easy to manufacture, relatively simple to operate and cost effective.

SUMMARY OF THE INVENTION

In one aspect, the invention provides a method for coating an electrically conductive fibre with superconductor particles characterised in that it comprises the steps of:

submersing an electrode from a voltage source into a container filled with a solution comprising propylene carbonate and having charged superconducting particles suspended in said solution to form a slurry;

connecting said fibre to said voltage source to establish said fibre as the counterelectrode thereof; and

submersing said fibre into said slurry to attach said particles thereto to coat said fibre.

In a further aspect, the invention provides an apparatus for electrically coating an electrically conductive substrate with superconductor particles characterised in that it comprises:

means for holding a slurry of superconductor particles suspended in a propylene carbonate solution;

means for influencing said slurry with an electrical field;

means for electrically biasing said substrate; and

means for suspending said substrate in said slurry to attach and coat said superconductor particles thereto; and

means external to said holding means for influencing said particles with a magnetic field to align said particles in a selected orientation on said substrate.

A preferred embodiment of the apparatus for manufacturing a ceramic superconductor coated electrically conductive fibre comprises a container for holding a nonaqueous solution of anhydrous propylene carbonate and ethanolamine in which charged particles of superconductor material, such as RE $Ba_2Cu_2O_{7-x}$, where RE is preferably dysprosium (Dy) or erbium (Er), are suspended to form a slurry. An electrode (e.g. anode) is electrically connected to a voltage source and is placed in electrical contact with the slurry. Similarly, the electrically conductive fibre substrate, which preferably comprises a nickel alloy, is electrically connected to the voltage source to establish a counterelectrode (e.g. cathode) and is submersed in the slurry. the voltage of the voltage source is then set to influence the slurry with an electric field having a level which causes the charged superconductor particles in the slurry to attach to the electrically conductive fiber substrate counterelectrode and coat the fiber with superconductor material.

A magnet device may be positioned externally to the container to influence the slurry with a magnetic field. Depending on the magnetic properties of the particular superconductor particles and the desired alignment of these particles on the fiber substrate, the field can be generally directed either parallel or perpendicular to the longitudinal axis of the fiber substrate. Further, in order to enhance uniform coating of the fiber in the presence of this magnetic field, the apparatus may have means to rotate either the fiber or the magnet device while the fiber is being drawn through the solution. Additionally, the apparatus may comprise means to continuously feed the electrically conductive fiber substrate into the slurry and to respectively withdraw the fiber therefrom once it is coated with superconductor particles.

In addition to the basic elements of the present invention which comprise the slurry container, magnet device and voltage source, means may be provided to maintain superconductor particle concentration in the nonaqueous solution at a substantially constant level. This is done by an incorporated control system which adds high concentration slurry through a supply valve on a holding tank to the slurry in the container and which simultaneously draws off low concentration slurry from the container through a drain valve on the container. A sampling probe can be provided and inserted into the container to take readings of the superconductor concentration levels in the slurry. A signal proportional to a reading can be used by electronic componentry to appropriately operate the supply valve and drain valve to maintain a substantially constant level of superconductor particle concentration in the container.

In the method for manufacturing a ceramic superconductor coated electrically conductive fiber, fine particles of superconductor material are suspended in a solution comprising isopropanol or propylene carbonate and ethanolamine. The resultant slurry is ultrasonically agitated and/or ball milled to disperse, charge and deagglomerate the particles prior to being influenced by the electric field. The fiber substrate is electrically connected to a voltage source to bias the fiber and it is then drawn through the slurry. While the fiber is being drawn through the slurry in a continuous operation, either the fiber or the magnet may be rotated in order to achieve a more uniform coating of magnetically aligned superconductor particles. After leaving the slurry with its superconductor particle coating, the coated fiber may be heated in the range of approximately 980°C to 1030°C to sinter the superconductor particles for RE = Dy and create a ceramic shell on the substrate. In general, the superconductor is sintered at a temperature from 5 to 50°C below its melting point.

In an improved embodiment of the present invention, the slurry is made with a solution of Dy 1-2-3 superconductor particles suspended in a mixture of anhydrous propylene carbonate and ethanolamine. Additionally, the magnet is removed from its near proximity to the slurry container and is repositioned to influence the coated fiber after it has passed through the slurry. Further, a fiber made of the commercially available Duranickel 301 alloy is used as the superconductor substrate and the coated fiber is sintered at a temperature below the melting temperature of the superconductor.

As a consequence of the changes made for the improved embodiment of the present invention, the coated fiber is preheated after it is withdrawn from the slurry. This preheating partially evaporates the relatively fluid propylene carbonate to a point where the superconductor particles in the coating can be oriented by a magnetic field, but will not thereafter disorient. The fiber is then subjected to a magnetic field to properly orient the superconductor particles and the coated fiber with aligned superconductor particles is further heated to remove all propylene carbonate from the coating. The superconductor particles are then sintered.

The improved embodiment of the present invention also includes a feedback control system for the voltage source which establishes the electric field in the slurry. In this feedback control system, a non-contacting micrometer, such as a laser micrometer is used to measure the diameter of the coated wire after it leaves the slurry. A process controller comparator establishes an error signal representative of the difference between the measured diameter of the coated fiber and a preselected diameter. This error signal is then used to adjust the electric field in the slurry to obtain the preselected diameter for the coated fiber and, hence, the desired thickness of the superconductor coating. Additionally, the improved embodiment of the present invention incorporates a pump to provide a continuous slurry circulation system between a slurry holding tank and the container wherein the electrophoresis procedure is accomplished.

The novel features of this invention, as well as the invention itself, both as to its structure and its operation, will be best understood from the accompanying drawings, taken in conjunction with the accompanying description, in which similar reference characters refer to similar parts, and in which:

BRIEF DESCRIPTION OF THE DRAWINGS

Figure 1 is a schematic of the apparatus with various portions shown in perspective, in cross section or in phantom for clarity;
Figure 2 is a perspective view of an alternate embodiment of the magnet device of the apparatus;
Figure 3 is an isometric view of an idealized superconductor crystalline particle;
Figures 4A and 4B illustrate desired alignments of superconductor particles in different magnetic fields; and
Figure 5 is a schematic of the improved embodiment of the apparatus.

DESCRIPTION OF THE PREFERRED EMBODIMENT

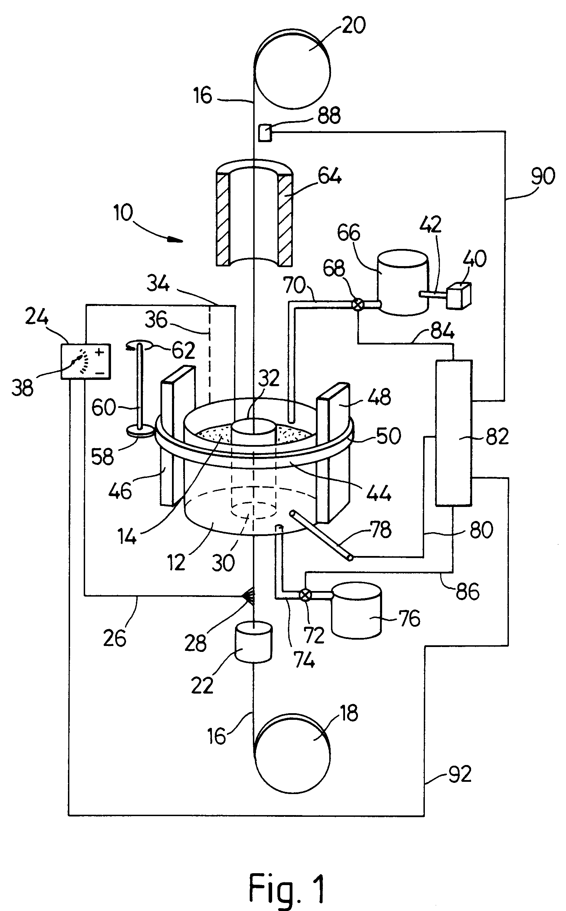

Referring initially to Figure 1, the apparatus for manufacturing a ceramic superconductor coated electrically conductive fiber is shown and generally designated 10. As shown, apparatus 10 includes a container 12 for holding a slurry 14 in which very fine particles of superconductor material are suspended. Preferably, the superconductor material is from the group identified as RE $Ba_2Cu_3O_{7-x}$ (where x is in the range of 0-1 and RE is a rare earth element). More specifically, the rare earths dysprosium (Dy) and erbium (Er) are preferred because their relatively high magnetic susceptibilities result in better alignment of the superconductor particles during the process disclosed below. When magnetic alignment of the superconductor grains is not required, yttrium (Y) is preferred. Importantly, when this preferred superconductor material is used, slurry 14 comprises a nonaqueous solution. Further, the nonaqueous solution should be nonreactive with the superconductor material and preferably comprise a solvent, such as anhydrous propylene carbonate with a relatively small amount (e.g., approximately 0.1-5% of the solution) of an additive, such as ethanolamine, which is dissolved in the solvent to enhance the superconductor material's electrical charge. It will be understood by the skilled artisan that other additives, such as dibutylamine, urea, or a product commercially known as Emphos P21, may be used instead of ethanolamine. In any event, the slurry 14 must remain effectively moisture-free and both the solvent (propylene carbonate) and the additive (ethanolamine) in slurry 14 should evaporate or decompose at relatively low temperatures (i.e. somewhere below 300° C) in order to prevent subsequent reactions of these ingredients with the superconductor material.

In accordance with the present invention, an electrically conductive substrate 16, on which the superconductor particles suspended in slurry 14 are to be coated, is fed into or suspended in the slurry 14. This substrate 16 may be formed as either a ribbon or a wire fiber. The actual form or configuration of substrate 16 is not, however, a limiting consideration. In fact, any configuration will work so long as it can function effectively as an electrode.

In addition to its electrical properties, substrate 16 should not interdiffuse with the superconductor particles. Thus, substrate 16 can be made of an inert metal such as gold or silver. When, however, a less expensive, more cost effective material is used (i.e., one which is not noble), substrate 16 will preferably lend itself to the establishment of an oxide barrier on its surface which will minimize the interdiffusion of substrate 16 with the superconductor particles. Thus, substrate 16 should either be made of an oxide forming material, such as the wires commercially available as Duranickel 301, Haynes 214 or Hoskins 875, or have a thin oxide layer deposited on it, such as barium zirconate ($BaZrO_3$). As another embodiment, substrate 16 could have an oxide layer comprising dysprosium oxide ($Dy_2O_3$).

In either case, the thin oxide layer may be deposited on substrate 16 by any appropriate technique, such as by electrophoresis, sol gel coating, evaporation, electroplating, or sputtering the oxide layer onto substrate 16. Preferably, substrate 16 is made of an oxide forming material such as described above. This is so because such a substrate 16 can be electrophoretically coated with superconductor particles at relatively low temperatures before being subjected to the much higher temperatures which are necessary to form an oxide barrier on the surface of substrate 16 (e.g., 850°C). In this regard, it is important to recognize that when an oxide forming material is used, the electrophoresis process necessarily precedes formation of the oxide barrier because an oxide barrier will tend to electrically insulate substrate 16. Suitable oxide forming materials for substrate 16 are materials, such as the commercially available materials discussed above: Duranickel 301, Haynes 214 or Hoskins 875. Such materials will create an effective oxide barrier between substrate 16 and the superconductor coating during subsequent procedures wherein the superconductor particles are sintered into a ceramic. Examples of such procedures are disclosed in a co-pending application for an invention entitled "Substrate for Ceramic Superconductor" which is assigned to the same assignee as the present invention. On the other hand, when a substrate 16 has a preformed oxide barrier, the barrier should not electrically insulate the substrate 16 to the point where an electrophoresis process is made ineffectual. The preferred substrate material, which is relatively non-magnetic, is Duranickel 301. Because a substrate which comprises Duranickel 301 is relatively non-magnetic, relatively circular coatings of superconductor material may be formed when electrophoretic coatings are applied in magnetic fields of typically 0.3 - 1.5 tesla. A $Ni_xAl_y$ compound, where x is greater than or equal to seventy-five (75) atomic percent and y is equal to (100 - x) atomic percent, is another such appropriate substrate material. Additionally, $Ni_xAl_yCu_z$ may also be used, where x is greater than or equal to sixty (60) atomic percent, y is in the range $0 \leq y \leq 25$ atomic percent, and z is in the range $0 \leq z \leq 15$ atomic percent. Likewise, $Ni_xAl_yB_z$ is a suitable composition which may be used for substrate 16, where x is greater than or equal to seventy-five (75) atomic percent, $0 \leq y \leq 25$ atomic percent, and $0 \leq z \leq 2$ atomic percent.

As shown in Figure 1, substrate 16 is fed from a supply spool 18 and through slurry 14 in container 12 to a take-up spool 20. More specifically, after leaving supply spool 18, substrate 16 is passed through a precleaner 22 (e.g., a furnace or a solvent in an ultrasonic bath) where it is cleaned of dust and other debris which may have settled onto the substrate 16 during handling. It will, however, be appreciated that no precleaner 22 is required if substrate 16 is sufficiently clean. As also shown in Figure 1, substrate 16 is electrically biased. For this purpose, a voltage source 24 is placed in electrical contact with substrate 16 through line conductor 26 by any means known in the art, such as brush 28. Further, it will be appreciated that voltage source 24 could also be a constant current device. Also, though not shown, it will be appreciated that substrate 16 can be electrically biased by any direct electrical connection between voltage source 24 and substrate 16. Regardless, after leaving supply spool 18, substrate 16 is then passed into container 12 via inlet 30.

In addition to being electrically connected with substrate 16, voltage source 24 is also electrically connected with an open-ended electrically conductive foil cylindrical tube 32, preferably made of silver. As shown in Figure 1, tube 32 is submersed in slurry 14 and is electrically connected to voltage source 24 via line 34. With this arrangement, slurry 14 in container 12 is influenced by the electric field established between an electrode (i.e., tube 32) and a counterelectrode (i.e., substrate 16). Alternatively, tube 32 can be eliminated and voltage source 24 directly connected to container 12 via line 36. This connection will then establish container 12 as the electrode of the apparatus 10. This, of course, requires that container 12 be made of an electrically conducting material. In either case, the respective electrodes are preferably 0.1 to 5 cm apart.

As shown in Figure 1, tube 32 is established as the anode and substrate 16 is established as the cathode. It will be appreciated by skilled artisans, however, that the polarities on electrodes and counterelectrodes can be alternated and, further, that the manipulation of rheostat 38 on voltage source 24 will vary the level of the voltage potential between anode and cathode. Typically, voltages of from 1-100 volts and corresponding currents in the range of 10 microamps to 1 milliamp are effective for the purposes of the present invention. Further, it is to be appreciated that rheostat 38 (or a digital voltage source) can be used to establish the voltage levels of the electric field influencing slurry 14 and thereby effectively establish the thickness of the coating of superconductor particles on substrate 16.

While varying the voltage level in slurry 14 is, perhaps, the most practical way by which to control coating thickness, it will be appreciated that other factors also affect this thickness. For instance, the concentration of superconductor particles in slurry 14, the time in which substrate 16 is submersed in slurry 14, the mobility of the superconductor particles through slurry 14 and the magnitude of the electric charge of the superconductor particles are all factors which affect the electrophoresis process. The electric field influencing slurry 14 is set to cause the superconductor particles, which are colloidally suspended in the slurry 14, to migrate toward substrate 16 and become attached thereto. This process will, of course, require that the superconductor particles carry a charge. To accomplish this, the superconductor particles are mixed with the nonaqueous solution and then agitated. Effective agitation can be done either ultrasonically or by milling the particles in a manner well-known in the pertinent art. Although slurry 14 should not be vibrated once it is placed into container 12, an effective way in which slurry 14 may be vibrated is by ultrasonic energy which is generated by an ultrasonic source 40 that is operatively connected to tank 66. A transducer probe 42 extends from source 40 into slurry 14 in container 66 to agitate the superconductor particles therein to charge the particles in a manner well-known in the art. It will be recalled that the additive ethanolamine in slurry 14 is also intended to enhance the charge on superconductor particles. Both the ethanolamine charging additive as well as the ultrasonic agitation effectively prevent or minimize the agglomeration of the fine (micron-sized) superconductor particles in the slurry into multiparticle agglomerates. Multiparticle agglomerates do not properly align in an external magnetic field during the electrophoresis process, nor do they sinter to high density during the subsequent sintering process.

An important feature of apparatus 10 is that slurry 14, in addition to being influenced by an electric field, is also influenced by a magnetic field. For this purpose, a magnet device 44 is provided. In Figure 1, the magnet device 44 is shown as a pair of permanent magnets, respectively designated 46 and 48, which are connected together by a flux return element 50 and positioned externally to container 12 on substantially opposite sides thereof. With this configuration, slurry 14 is effectively influenced by a magnetic field whose strength and uniformity is dependent, in part, on the size of magnets 46, 48 and whose flux lines within slurry 14 are substantially aligned in a direction which is perpendicular to the longitudinal axis of substrate 16.

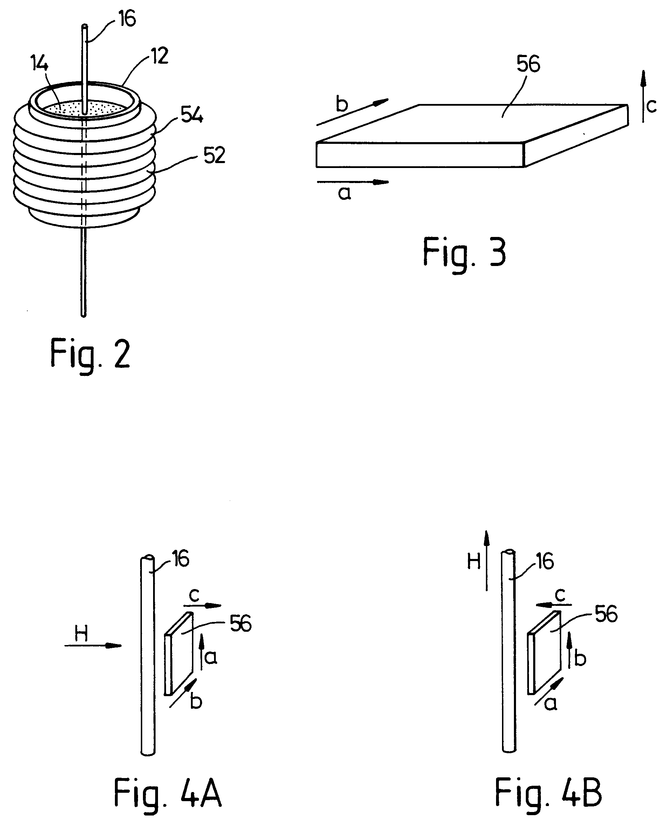

In an alternate embodiment, a magnet device 52, comprising a solenoid winding 54, as shown in Figure 2, may be used. The magnetic field strength of this magnet device 52 will depend, in part, on the current in winding 54 and the direction of the flux lines generated by magnet device 52 will be in a direction which is substantially parallel to the longitudinal axis of substrate 16. From the discussion below, it will be seen that it is important for,the direction of flux to be compatible with the magnetic properties of the 1-2-3 particles. In either embodiment, magnetic fields of between .3 and 1.5 tesla are preferred. More specifically, relatively higher magnetic fields will result in relatively improved alignment of the superconductor particles on substrate 16. In particular, the least paramagnetic of the $REBa_2Cu_3O_7$ materials, namely RE = Y, La, or Lu will require higher magnetic grain aligning fields of typically 3 to 8 tesla.

An exemplary configuration of a superconductor particle is shown as plate 56 in Figure 3. In this form, it is known that the critical current densities ($J_c$) of the plate 56 vary according to the axis along which current flows. Specifically, $J_c$ in both the "a" and "b" directions shown in Figure 3 are on the order of thirty (30) times greater than $J_c$ in the "c" direction. Accordingly, in order to optimize current flow in the resultant product, it is desirable if plates 56 are properly oriented on substrate 16 with their respective "c" directions substantially perpendicular to the longitudinal axis of substrate 16. The magnetic field generated by magnet device 44 or magnet device 52 is intended to accomplish this.

Fortunately, with the use of RE $Ba_2Cu_3O_{7-x}$ (i.e. 1-2-3) as the superconductor material, the orientation of a plate 56 in a magnetic field of flux H is, at least to some extent, predictable. Specifically, some rare earth 1-2-3 materials orient in a flux field H with their "c" direction parallel to the lines as shown in Figure 4A, while others orient themselves with their "c" direction perpendicular to the lines of flux as shown in Figure 4B. For example, the rare earth elements which orient with the "c" direction parallel to H include yttrium (Y), neodymium (Nd), samarium (Sm), dysprosium (Dy) and holmium (Ho). On the other hand, the rare earth elements which orient with the "c" direction perpendicular to H include europium (Eu), erbium (Er), thulium (Tm) and ytterbium (Yb). Thus, magnet device 44 may be better suited for use with some rare earth superconductors, while magnet device 52 will be better suited for the others.

In the particular case shown in Figure 4A, where plate 56 orients with its "c" direction parallel to H, there is the potential for a nonuniform anisotropic coating of substrate 16 due to the relative thinness of plate 56 in its "c" direction. To overcome this potential problem, substrate 16 can be rotated during the coating process or the magnet device itself can be rotated. Though not shown, it will be appreciated that substrate 16 may be rotated by any means well-known in the art. Further, substrate 16 need not necessarily pass through slurry 14. Instead, substrate 16 may be suspended in slurry 14 and rotated therein. In any case, to avoid an anisotropic coating, it is necessary to charge substrate 16 and rotate it in slurry 14 to obtain a uniform coating of the magnetically influenced superconductor particles. Referring back to Figure 1, it will be appreciated that magnet device 44 can be slidingly mounted on container 12 for rotation with respect thereto. A roller 58 can be operatively engaged with magnet device 44, by any means well-known in the art, so that rotation of roller 58 about an axis 60 in the direction of arrow 62 will cause magnet device 44 to rotate about container 12 while maintaining flux lines in slurry 14 substantially perpendicular to the longitudinal axis of substrate 16. Thus, an anisotropic coating of substrate 16 can be obviated.

As shown in Figure 1, magnets 44, 46 partially extend above container 12. Accordingly, the superconductor particles from slurry 14 which attach to substrate 16 continue to be influenced by a magnetic field even after passing through slurry 14. This configuration is established in order to keep the superconductor particles properly aligned on substrate 16 during the evaporation of nonaqueous solution, and prior to sintering.

An oven 64 is provided to sinter the superconductor particles which are attached to substrate 16 into a ceramic. The ceramic superconductor coated substrate 16 can then be wound onto take-up spool 20 and used thereafter as desired.

During the continuous process of coating substrate 16 with superconductor particles, it may be desirable to maintain the concentration of superconductor particles in slurry 14 at a substantially constant level. To accomplish this, a slurry 14 having slightly higher superconductor particle concentration levels than desired for use in container 12 is provided and held in supply tank 66. The operation of supply valve 68 will open pipe 70 and allow high concentration slurry 14 from supply tank 66 to be introduced into the slurry 14 in container 12. Simultaneously, operation of drain valve 72 allows low concentration slurry 14 in container 12 to be withdrawn from container 12 through pipe 74 into holding tank 76.

The maintenance of superconductor concentration levels in container 12 can be accomplished with a closed loop feedback control system. In this system, a probe 78 is inserted into slurry 14 and is used to test samples of slurry 14 for viscosity, electrical conductivity, or other pertinent parameter known in the art and generate a reading of the superconductor concentration levels in the samples. Probe 78 may be of any type well-known in the art for testing fluid viscosity. This reading is transmitted via line 80 to a microprocessor 82 which, depending on the concentration level indicated by the reading from probe 78, will transmit signals via lines 84, 86 to supply valve 68 and drain valve 72, respectively, to charge the flow through the valves 68, 72 to effectively maintain the concentration of superconductor particles in slurry 14 in container 12 at the desired level.

The thickness of the superconductor ceramic coating of substrate 16 can be automatically controlled using microprocessor 82 in a standard closed loop feedback control system similar to the one used for controlling slurry 14 superconductor concentration. Specifically, any device 88, such as a laser micrometer, that is well-known in the art for noncontact measurement of the diameter of a wire, can be positioned relative to substrate 16 to determine the diameter of the ceramic coated substrate 16. More specifically, the device 88 can include an emitter 89 and a detector 91 which function for the stated purpose in a manner well-known in the pertinent art. This measurement can then be sent as an electrical signal via line 90 to a controller, such as microprocessor 82. The controller or microprocessor 82 then compares the signal from device 88 with a predetermined reference level to establish an error signal. This error signal is then sent via line 92 to rheostat 38 and, depending on the sign and magnitude of this error signal, rheostat 38 is moved to vary the voltage level of source 24 to control the thickness of superconductor ceramic coating on substrate 16.

It is to be appreciated that when 1-2-3 superconductor materials are used, the herein disclosed method for coating an electrically conductive substrate 16 with a superconductor coating must be accomplished in a substantially moisture-free environment. This is so in order to preserve the coatability of the slurry and prevent contamination of the superconductor material. Accordingly, it is preferable that apparatus 10 be enclosed in a dry room where the ambient humidity and carbon dioxide concentrations can be controlled and maintained at very low levels.

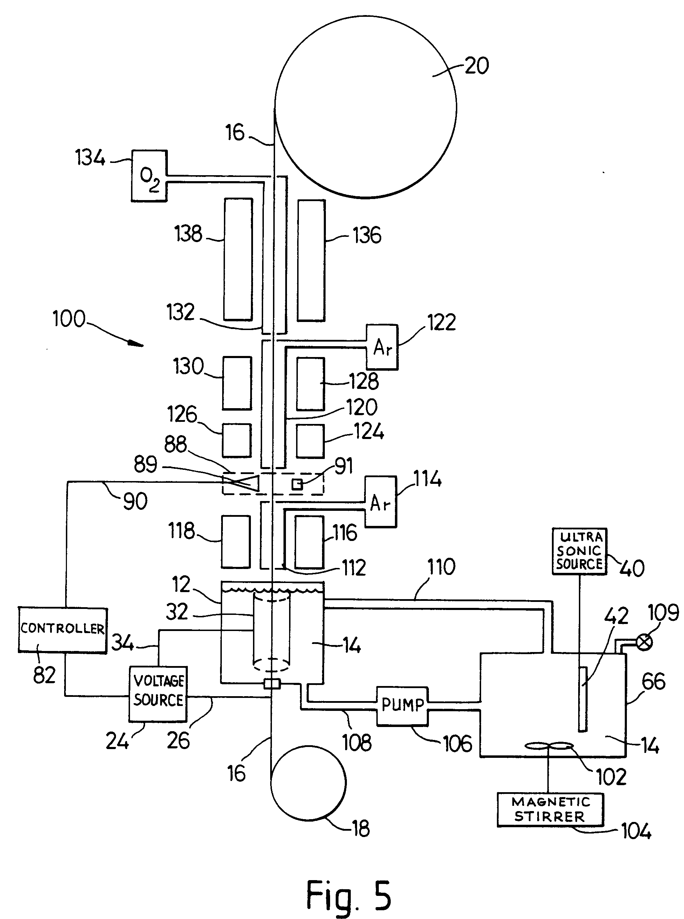

Referring now to Figure 5, an improved embodiment of an apparatus for manufacturing a ceramic superconductor coated electrically conductive fiber is shown and generally designated 100. As will be readily appreciated, many components of improved apparatus 100 are the same or similar to components previously disclosed for apparatus 10. The main differences between apparatus 10 and apparatus 100 being the placement and incorporation of components along the path of substrate 16 for aligning and sintering superconductor particles on substrate 16 after the substrate 16 has been passed through slurry 14. As will be seen, this reconfiguration is done for the dual purposes of i) accomplishing the physical characteristics of a superconductor coating which comes from a slurry 14 that comprises a solution of Dy 1-2-3 superconductor particles suspended in a mixture of anhydrous propylene carbonate and ethanolamine, and ii) improving the sintering process for such a coating.

In Figure 5, it will be seen that in addition to the agitation provided by ultrasonic transducer probe 42 to charge and deagglomerate the superconductor particles in slurry 14, the slurry 14 is stirred by a paddle 102 which is activated by a magnetic stirrer 104. A peristaltic pump 106 is also provided to pump slurry 14 from supply tank 66 through feeder line 108 and into container 12. Figure 5 also shows that excess slurry 14 in container 12 can be drawn from the container 12 back through line 110 and into supply tank 66. Further, Figure 5 shows an inlet valve 109 through which replacement slurry can be added into tank 66. As will be appreciated, with this recirculation of slurry 14 between supply tank 66 and container 12, the composition of slurry 14 can be monitored in supply tank 66 and adjusted to properly maintain the desired concentration of superconductor particles for slurry 14, in container 12.

Similar to the above disclosure regarding apparatus 10, for the apparatus 100 a voltage source 24 is electrically connected to substrate 16 and container 32 to respectively establish a counterelectrode and an electrode for the electrophoresis process. With this well-known procedure, a coating is deposited on substrate 16. As shown in Figure 5, after coated substrate 16 has passed through slurry 14, it is preheated in an inert environment. Specifically, substrate 16 enters chamber 112 which is filled with an inactive gas, e.g., argon, that is supplied by a source 114. While substrate 16 is in chamber 112 it is preheated by heaters 116 and 118 for approximately twenty (20) seconds to a temperature in the range of 50°-100°C. This preheating is necessary in order to partially evaporate the propylene carbonate in the coating on substrate 16. The object here is to leave the coating sufficiently fluid so that grains of superconductor particles can be properly oriented in the coating under the influence of a magnetic field, yet have the coating sufficiently viscous so that the grains will not change their orientation once they leave the influence of the magnetic field.

After being preheated by heaters 116, 118, the diameter of substrate 16 is measured by a non-contact laser/optical micrometer device 88 of a type well-known in the pertinent art. As with apparatus 10, this measurement is used by microprocessor controller 82 to vary the output of voltage source 24 in a manner which will control the coating of substrate 16 by the electrophoresis process to the desired thickness. Substrate 16 then passes into a chamber 120 which is filled with an inert gas, e.g., argon, from a source 122. While in chamber 120 substrate 16 is influenced by magnets 124 and 126 to align superconductor particles on substrate 16. In accordance with the above disclosure and with reference to Figure 3, it is preferable that each superconductor particle be influenced by magnets 124, 126 to align the "c" axis of the superconductor particle perpendicular to the longitudinal axis of substrate 16. Once the superconductor particles are properly aligned, substrate 16 is heated by heaters 128 and 130 to a temperature of approximately 300°C for approximately fifteen (15) seconds in order to complete the evaporation of all remaining propylene carbonate from the coating on substrate 16.

With all propylene carbonate evaporated from the coating on substrate 16, the substrate 16 is drawn into a quartz tube 132 which contains an oxygen environment supplied by source 134. While in quartz tube 132, substrate 16 is heated by the heaters 136 and 138 to sinter the superconductor particles into a ceramic on substrate 16. Specifically, heaters 136, 138 heat substrate 16 in a range between 980°-1030°C for approximately one to ten (1-10) minutes for $DyBa_2Cu_3O_{7-x}$ superconductor. In general, the superconductor is sintered at a temperature from 5 to 50°C below its melting point. During the processing of substrate 16 in accordance with the present invention, a Duranickel 301 wire having an outside diameter of approximately three (3) mil is transformed into a superconducting filament having an outside diameter in the range of eight to fifteen (8-15) mil.

As indicated above, the preferred substrate 16 for use with the improved apparatus 100 of the present invention is a wire which is commercially available under the trade name Duranickel 301. This substrate 16 is typically available on a supply spool 18 which is on the order of five (5) inches in diameter. On the other hand, take up spool 20 is preferably on the order of eighteen (18) in diameter in order to minimize stress on the ceramic superconductor after substrate 16 has been electrophoretically coated in container 12 and sequentially processed by magnets 124, 126 and the various heaters 116, 118, 128, 130, 136 and 138.

While a particular apparatus for manufacturing a superconductor as herein shown and disclosed in detail is fully capable of obtaining the objects and providing the advantages herein before stated, it is to be understood that it is merely illustrative of the presently preferred embodiments of the invention and that no limitations are intended to the details of construction or design herein shown other than as described in the appended claims.

## Claims

1. A method for coating an electrically conductive fibre (16) with superconductor particles characterised in that it comprises the steps of:

   submersing an electrode from a voltage source (24) into a container (12) filled with a solution comprising propylene carbonate and having charged superconducting particles suspended in said solution to form a slurry (14);

   connecting said fibre (16) to said voltage source (24) to establish said fibre (16) as the counterelectrode thereof; and

   submersing said fibre (16) into said slurry to attach said particles thereto to coat said fibre (16).

2. A method according to claim 1 further comprising the step of activating said voltage source (24) to generate a voltage in the range between 1 and 100 volts.

3. A method according to claim 1 or 2 further comprising the step of positioning a magnet device (44) external to said container (12) to influence said particles with a magnetic field for aligning said particles in a selected orientation on said fibre (16).

4. A method according to any one of claims 1 to 3 wherein said solution further comprises ethanolamine charging agent.

5. A method according to any one of the preceding claims wherein said fibre (16) is made of Duranickel 301.

6. A method according to any one of the preceding claims further comprising the steps of agitating said slurry (14) and continuously circulating said slurry (14) to maintain a desired concentration of suspended superconductor particles in said slurry (14).

7. A method according to any one of the preceding claims further comprising the step of monitoring the diameter of said coated fibre (16) to vary the voltage of said voltage source (24) to maintain a predetermined diameter for said coated fibre (16).

8. A method according to any one of the preceding claims wherein the step of submersing said fibre (16) into said slurry (14) comprises drawing said fibre (16) into said slurry (14) through an inlet and withdrawing said substrate with said attached superconductor particles from said slurry (14).

9. A method according to any one of the preceding claims further comprising the step of maintaining the concentration of said suspended particles in said slurry (14) at a substantially constant level.

10. A method according to any one of the preceding claims further comprising the step of maintaining said container (12) and said slurry (14) in a substantially moisture-free environment.

11. A method according to any one of the preceding claims further comprising the step of varying the voltage of said voltage source (24) to obtain the desired thickness of said superconductor particles on said fibre (16).

12. A method according to any one of the preceding claims further comprising the step of agitating said slurry (14) before placing said slurry (14) in said container (12) to enhance the electrical charge on said superconductor particles.

13. A method according to any one of the preceding claims further comprising the step of milling said superconductor particles to enhance the charge on said superconductor particles.

14. A method according to any one of the preceding claims wherein said slurry (14) is prepared by agitating and mixing together propylene carbonate and superconductor particles and ethanolamine.

15. A method according to any one of the preceding claims wherein after withdrawing said substrate (16) from said slurry (14) said propylene carbonate is heated to between 50°C and 200°C, inclusive.

16. A method according to any one of the preceding claims further comprising the step of sintering said particles at a temperature 5 to 50°C below their melting point for a time of from one to ten (1-10) minutes.

17. An apparatus (10) for electrically coating an electrically conductive substrate (16) with superconductor particles characterised in that it comprises:

means for holding a slurry (14) of superconductor particles suspended in a propylene carbonate solution;

means for influencing said slurry (14) with an electrical field;

means for electrically biasing said substrate (16); and

means for suspending said substrate (16) in said slurry (14) to attach and coat said superconductor particles thereto; and

means external to said holding means for influencing said particles with a magnetic field to align said particles in a selected orientation on said substrate (16).

18. An apparatus according to claim 17 wherein said holding means is a container (12).

19. An apparatus according to claim 17 or 18 further comprising means for drawing said substrate (16) with said attached superconductor particles from said slurry (14) and wherein said means for influencing said substrate with a magnetic field is a magnet device (44) externally positioned relative to said container (12) to influence said particles after said particles are attached to said substrate (16) and are withdrawn from said slurry (14).

20. An apparatus according to any one of claims 17 to 19 wherein said means for influencing said slurry with an electric field is a voltage source (24) electrically connected with said container (12) to establish said container (12) as an electrode and electrically connected with said substrate (16) to establish said substrate (16) as a counterelectrode.

21. An apparatus according to claim 20 wherein said voltage source (24) generates a voltage in the range between 1 and 100 volts.

22. An apparatus according to any one of claims 17 to 21 further comprising means (40) for agitating and circulating said slurry (14) of superconductor particles to maintain a desired concentration of superconductor particles in said slurry (14).

23. An apparatus according to any one of claims 17 to 22 wherein said substrate (16) is a wire made of Duranickel 301.

24. An apparatus according to any one of claims 17 to 23 further comprising means for submersing said substrate (16) into said slurry (14) which comprises drawing said substrate (16) into said slurry (14) through an inlet and withdrawing said substrate with said attached superconductor particles from said slurry (14).

Fig. 1

Fig. 2

Fig. 3

Fig. 4A

Fig. 4B

Fig. 5